# EUROPEAN PATENT SPECIFICATION

(11) **EP 2 942 631 B1**
(45) Date of publication and mention of the grant of the patent: **06.03.2024**
(21) Application number: 15164539.7
(22) Date of filing: 21.04.2015
(51) Int. Cl.: G01R 1/20, G01R 15/20

(54) **HYBRID CURRENT SENSOR ASSEMBLY**
HYBRIDSTROMSENSORANORDNUNG
ENSEMBLE DE CAPTEUR DE COURANT HYBRIDE

(30) Priority: 28.04.2014 KR 20140050656; 18.09.2014 KR 20140124358
(43) Date of publication of application: 11.11.2015
(73) Proprietor: TYCO ELECTRONICS AMP KOREA Co., Ltd., Gyeongsangbuk-do, 38459 (KR)
(72) Inventor: Chae, Hong Il, Gyungsangbuk-do 712-838 (KR); Choi, You Sik, Gyungsangbuk-do 712-838 (KR); Kang, Shin Wook, Gyungsangbuk-do 712-838 (KR); Kim, Young Woon, Gyungsangbuk-do 712-838 (KR)
(74) Representative: Johnstone, Douglas Ian

(56) References cited:
- EP-A2- 2 667 397
- US-A1- 2007 279 175
- US-A1- 2012 262 151

## Description

The present invention relates to a hybrid current sensor assembly.

A current sensor is an electronic component that senses an electric current. The current sensor is provided in various types, for example, a Hall sensor and a shunt sensor.

A Hall effect refers to a physical phenomenon in which a potential difference occurs at both ends of an electrical conductor when a magnetic field is interlinked with the conductor in which an electric current flows. The potential difference induced by such a Hall effect is proportional to the interlinked magnetic field. Using the Hall effect, a Hall sensor sends a bias current to the conductor to measure the potential difference at both ends and measure a strength of the magnetic field. For example, Korean Patent Publication No. 10-2011-0017774 discloses a Hall sensor.

The Hall sensor and the shunt sensor have respective advantages and disadvantages. Generally, one of the two sensors is selectively used based on the performance of each. However, recent reinforcement of safety specifications requires the use of both. Accordingly, a production cost and a volume of a product increases by independently installing the two sensors.

US 2012/0262151 discloses an on-board circuit for a vehicle, the on-board circuit comprising a sensor assembly and a sensor controller. The sensor assembly has a conductor, a Hall sensor, and a shunt terminal, and the sensor controller has a microcontroller.

EP 2667397 discloses a DC circuit breaker having a DC shunt and an electric load side terminal. A Hall sensor assembly surrounds the electric load side terminal and has a pair of magnetic cores with a Hall sensor in between. The Hall sensor is connected to a printed circuit board of the Hall sensor assembly by pins. An electric load is between the DC shunt and the electric load side terminal and voltage signals from the DC shunt and the Hall sensor are transmitted to a microprocessor of an overcurrent relay.

The present invention provides a hybrid current sensor assembly into which two types of sensors are integrated.

According to the present invention, there is provided a hybrid current sensor assembly comprising: a conductor configured to be connected to both terminals of an external electronic device; a Hall sensor in which a potential difference occurs at both ends thereof due to a magnetic field applied to a Hall core; a shunt terminal; a shunt resistance configured to shunt the current flowing in the conductor; a microprocessor electrically connected to the shunt terminal and configured to measure the current flowing in the conductor; and a circuit board to which the Hall sensor and the shunt terminal are connected, wherein the circuit board has the microprocessor mounted thereto, wherein the hybrid current sensor assembly comprises the Hall core to which the magnetic field generated by a current flowing in the conductor is applied, wherein the Hall core is configured such that the magnetic field is concentrated on the Hall sensor, and comprises a first face to cover a bottom side of the conductor, and a second face and a third face bent correspondingly from both edges of the first face and covering both edges of the conductor; and the circuit board comprises a core insertion portion into which the Hall core is inserted.

The hybrid current sensor assembly may further include a housing to accommodate the Hall core, the Hall sensor, the shunt terminal, and the microprocessor. At least a portion of the conductor may be accommodated in the housing, and both end portions of the conductor may be externally exposed from the housing.

The core insertion portion may be a slot formed in the circuit board, and at least one of the second face and the third face may be disposed to pass the circuit board through the core insertion portion.

The Hall core may include a first end portion and a second end portion bent correspondingly from the second face and the third face towards a direction in which the first end portion and the second end portion face each other.

The core insertion portion may be a groove linearly recessed in an inward direction from an edge of the circuit board, and at least one of the second face and the third face may be slidingly connected to the circuit board through the core insertion portion.

The Hall core may be provided in a form to cover the conductor and the circuit board.

The Hall sensor may be disposed in a gap formed between the first end portion and the second end portion of the Hall core.

These and/or other aspects, features, and advantages of the invention will become apparent and more readily appreciated from the following description of exemplary embodiments, taken in conjunction with the accompanying drawings of which:
FIG. 1 is a perspective view of a hybrid current sensor assembly according to an embodiment of the present invention;
FIG. 2 is an exploded perspective view of a hybrid current sensor assembly according to an embodiment of the present invention;
FIG. 3 is a perspective view of an internal structure of a hybrid current sensor assembly according to an embodiment of the present invention;
FIG. 4 is a perspective view of a Hall sensor module according to an embodiment of the present invention;
FIG. 5 is a perspective view of a shunt sensor module according to an embodiment of the present invention;
FIG. 6 is an exploded perspective view of a hybrid current sensor assembly according to another embodiment of the present invention; and
FIG. 7 is a perspective view of an internal structure of the hybrid current sensor assembly according to another embodiment of the present invention.

Hereinafter, some example embodiments will be described in detail with reference to the accompanying drawings. Regarding the reference numerals assigned to the elements in the drawings, it should be noted that the same elements will be designated by the same reference numerals, wherever possible, even though they are shown in different drawings. Also, in the description of embodiments, detailed description of well-known related structures or functions will be omitted when it is deemed that such description will cause ambiguous interpretation of the present disclosure.

In addition, terms such as first, second, A, B, (a), (b), and the like may be used herein to describe components. Each of these terminologies is not used to define an essence, order or sequence of a corresponding component but used merely to distinguish the corresponding component from other component(s). It should be noted that if it is described in the specification that one component is "connected", "coupled", or "joined" to another component, a third component may be "connected", "coupled", and "joined" between the first and second components, although the first component may be directly connected, coupled or joined to the second component.

The terminology used herein is for the purpose of describing particular embodiments only and is not intended to be limiting. As used herein, the singular forms "a," "an," and "the," are intended to include the plural forms as well, unless the context clearly indicates otherwise. It will be further understood that the terms "comprises," "comprising," "includes," and/or "including," when used herein, specify the presence of stated features, integers, steps, operations, elements, and/or components, but do not preclude the presence or addition of one or more other features, integers, steps, operations, elements, components, and/or groups thereof.

A battery management system (BMS) of an electric vehicle (EV), a hybrid electric vehicle (HEV), and a plug-in hybrid electric vehicle (PHEV) may use a voltage value or a current value to calculate a state of charge (SoC) and a state of health (SoH).

According to an embodiment of the present invention, a hybrid current sensor is provided by combining a Hall current sensor and a shunt current sensor and thus, may have a redundancy dual output and low and high current ranges.

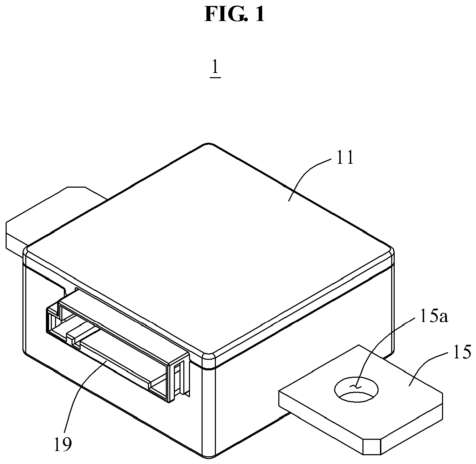

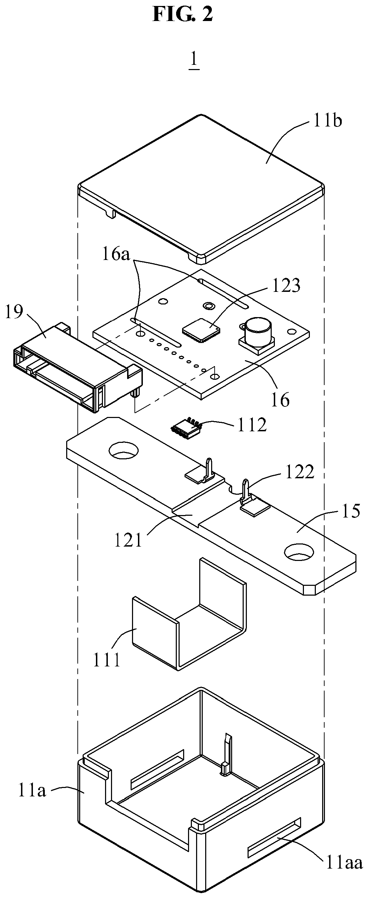

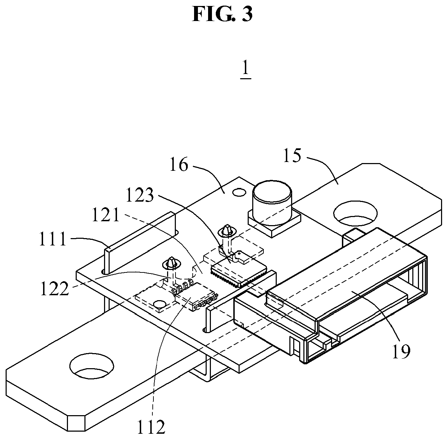

FIG. 1 is a perspective view of a hybrid current sensor assembly 1 according to an embodiment of the present invention, FIG. 2 is an exploded perspective view of the hybrid current sensor assembly 1, and FIG. 3 is a perspective view of an internal structure of the hybrid current sensor assembly 1.

Referring to FIGS. 1 through 3, the hybrid current sensor assembly 1 is connected to an external electronic device and configured to measure a value of a current flowing in the electronic device. The hybrid current sensor assembly 1 includes a housing 11, a conductor 15, a circuit board 16, a connector 19, a Hall core 111, a Hall sensor 112, a shunt resistance 121, a shunt terminal 122, and a microprocessor 123.

The housing 11 forms an exterior of the hybrid current sensor assembly 1. The housing 11 is provided in a rectangular form. However, a shape of the housing 11 is not limited to an illustrative example. The housing 11 includes a housing body 11a and a housing cover 11b.

The housing body 11a includes an accommodation space to accommodate therein electronic components. The housing body 11a includes a conductor insertion portion 11aa into which the conductor 15 is inserted. For example, the conductor insertion portion 11aa is a slot formed to correspondingly face both side faces of the housing body 11a. A first connector insertion portion into which the connector 19 is inserted is provided at one side of the housing body 11a. For example, the first connector insertion portion is a groove formed by being recessed at the one side of the housing body 11a.

The housing cover 11b covers at least a portion of the accommodation space of the housing body 11a. A second connector insertion portion into which the connector 19 is inserted is provided at one side of the housing cover 11b. For example, the second connector insertion portion is a groove formed by being recessed at the one side of the housing cover 11b.

At least a portion of the conductor 15 is disposed in the housing 11. The external electronic device is connected to both sides of the conductor 15. At both sides of the conductor 15, a connection portion 15a to which both terminals of the external electronic device are connected is formed. For example, the connection portion 15a is a hole formed in the conductor 15. The conductor 15 is disposed to penetrate the housing 11. The conductor 15 is externally exposed from the housing 11. In detail, both end portions of the conductor 15 are exposed from both sides of the housing 11. That is, both end portions of the conductor 15 externally protrude from both sides of the housing 11. The conductor 15 is a plate in a rectangular form. The conductor 15 is disposed to penetrate a center of the Hall core 111.

The Hall sensor 112, the shunt terminal 122, the microprocessor 123, and the connector 19 are arranged in the circuit board 16. The circuit board 16 includes a circuit to connect the electronic components to be arranged in the circuit board 16 to one another. The circuit board 16 includes a core insertion portion 16a into which the Hall core 111 is inserted. For example, the core insertion portion 16a is a slot formed to penetrate the circuit board 16. The core insertion portion 16a is formed to correspond to a form of the Hall core 111. For example, the core insertion portion 16a is provided in the form of a slit, which is linearly formed.

Both the Hall sensor 112 and the microprocessor 123 are connected to the single circuit board 16. The Hall sensor 112 and the microprocessor 123 are connected to a front face and a back face of the circuit board 16, respectively. The Hall sensor 112 and the microprocessor 123 are disposed to allow at least a portion to overlap in a vertical direction of the circuit board 16. In such a case, an area of the circuit board 16 used for installing the Hall sensor 112 and the microprocessor 123 may be reduced and thus, an overall width of the hybrid current sensor assembly 1 may be reduced.

Dissimilar to FIG. 3, both the Hall sensor 112 and the microprocessor 123 are connected to any one of the front face and the back face of the circuit board 16. In such a case, an overall height of the Hall sensor 112, the microprocessor 123, and the circuit board 16 may be reduced and thus, a height of the entire product may be reduced.

The connector 19 functions as a path to externally transmit information sensed by the Hall sensor 112 or the microprocessor 123. In addition, the connector 19 functions as a path to supply power to the electronic components arranged in the circuit board 16 from an external source. A portion of the connector 19 is disposed in the housing 11, and a remaining portion is disposed to be externally exposed from the housing 11.

A magnetic field generated by a current flowing in the conductor 15 is applied to the Hall core 111. The Hall core 111 is provided in a form to cover at least a portion of the conductor 15. The Hall core 111 includes a portion covering at least a portion of the conductor 15 in a direction perpendicular to a longitudinal direction of the conductor 15. The Hall core 111 includes a first face covering a bottom side of the conductor 15, and a second face and a third face bent from both edges of the first face and covering both sides of the conductor 15. That is, the Hall core 111 is provided in a flattened-U shape. At least one of the second face and the third face of the Hall core 111 is disposed to penetrate the circuit board 16 through the core insertion portion 16a.

The Hall sensor 112 senses the current based on the magnetic field applied to the Hall core 111. The Hall sensor 112 is disposed on an inner side of the Hall core 111. A potential difference occurs at both ends of the Hall sensor 112 due to the magnetic field applied to the Hall core 111. The Hall sensor 112 is disposed around a center of the Hall core 111. In such a case, a sensitivity of the Hall sensor 112 may be improved.

The Hall core 111 and the Hall sensor 112 are collectively referred to as a Hall sensor module 110. The Hall sensor module 110 senses information on the current flowing in the conductor 15 using a Hall effect.

The shunt resistance 121 is disposed at a center of the conductor 15. The conductor 15 includes a first conductor and a second conductor correspondingly connected to both sides of the shunt resistance 121. The first conductor, the shunt resistance 121, and the second conductor are sequentially connected in series. A resistance value of the shunt resistance 121 is determined based on a magnitude of the current to be measured.

The shunt terminal 122 shunts the current flowing in the conductor 15. The shunt terminal 122 connects the conductor 15 to the circuit board 16. The shunt terminal 122 allows the microprocessor 123 to be connected in parallel with respect to the conductor 15. The shunt terminal 122 includes a first shunt terminal and a second shunt terminal to connect the first conductor and the second conductor to two points of the circuit board 16, respectively. The first shunt terminal and the second shunt terminal are connected to the microprocessor 123. The first shunt terminal and the second shunt terminal are disposed on each side of the shunt resistance 121. The first shunt terminal and the second shunt terminal are disposed separate from each other not to be directly connected to the shunt resistance 121.

For example, the microprocessor 123 is disposed on an opposite side of the Hall sensor 112 based on the circuit board 16. Alternatively, both the Hall sensor 112 and the microprocessor 123 are disposed on one face of the circuit board 16. The microprocessor 123 is disposed separately from a center of the Hall core 111. In such a case, an influence of the magnetic field applied to the Hall core 111 on the microprocessor 123 may be reduced.

The microprocessor 123 is connected to the shunt terminal 122 to measure the current flowing in the conductor 15. Thus, the microprocessor 123 may function as a shunt sensor.

In addition, the microprocessor 123 measures the current flowing in the conductor 15 based on information sensed by the Hall sensor 112. In such a case, the microprocessor 123 senses the potential difference occurring at both ends of the Hall sensor 112 due to the magnetic field applied to the Hall core 111, and measures the current flowing in the conductor 15. When a value of the current measured by the Hall sensor module 110 is referred to as a first current value, and a value of the current measured by a shunt sensor module 120 is referred to as a second current value, the microprocessor 123 externally transmits, selectively or simultaneously, the first current value and the second current value, through the connector 19.

Here, the shunt resistance 121, the shunt terminal 122, and the microprocessor 123 are collectively referred to as the shunt sensor module 120. The shunt sensor module 120 measures information on the current flowing in the conductor 15 based on a shunt principle.

Based on a structure of the hybrid current sensor module 1 described in the foregoing, each of the Hall sensor module 110 and the shunt sensor module 120 measures the current flowing in the single conductor 15.

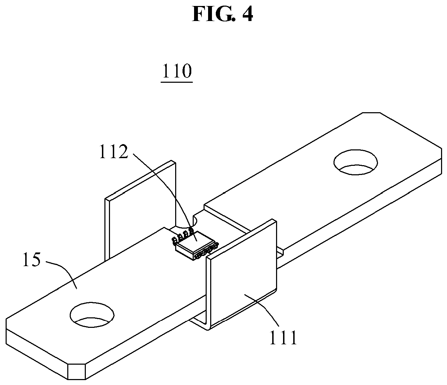

FIG. 4 is a perspective view of the Hall sensor module 110. For ease of description, the circuit board 16, the shunt terminal 122, and the microprocessor 123 are not illustrated in FIG. 4.

Referring to FIG. 4, the Hall sensor module 110 includes the conductor 15, the Hall core 111, and the Hall sensor 112.

When a current flows in the conductor 15, a magnetic field proportional to the current flowing in the conductor 15 is induced around the conductor 15 based on Ampere's law. The induced magnetic field magnetizes the Hall core 111, and a magnetic flux amplified at a center of the Hall core 111 in a flattened-U shape may be interlinked. Such a magnetic flux may lead to a Hall effect in the Hall sensor 112. Thus, a voltage, which is a potential difference proportional to the magnetic field induced by the current flowing in the conductor 15, may be output from the Hall sensor 112.

A value output from the Hall sensor 112 is transmitted to the microprocessor 123 and thus, a value of the current flowing in the conductor 15 is measured.

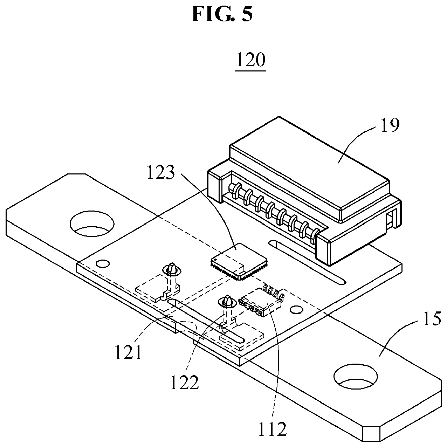

FIG. 5 is a perspective view of the shunt sensor module 120. For ease of description, the Hall core 111 and others are not illustrated in FIG. 5.

Referring to FIG. 5, the shunt sensor module 120 includes the conductor 15, the shunt resistance 121, the shunt terminal 122, and the microprocessor 123.

When a current flows in the conductor 15, the current flowing in the conductor 15 generates a voltage drop in the shunt resistance 121. Since a resistance value of the shunt resistance 121 is predetermined, the microprocessor 123 measures voltage values at a front end and a back end of the shunt resistance 121 and calculates a difference between the voltage values based on Ohm's law to determine a current flowing in the shunt resistance 121.

Table 1 indicates respective performances of the Hall sensor module 110 and the shunt sensor module 120, and a performance of the hybrid current sensor assembly 1 using the Hall sensor module 110 and the shunt sensor module 120.

**[Table 1]**

| Measured items | Hall sensor | Shunt sensor | Hybrid |
|---|---|---|---|
| Response time | 10 µs | 1000 µs | 10 µs |
| Accuracy | 1.5 % | 0.5 % | 0.5 % |
| Zero offset current | ±1.35 A | ±0.5 A | ±0.5 A |
| Output channel | 1 | 1 | 2 |
| Redundancy | X | X | O |

Referring to Table 1, each of the Hall sensor module 110 and the shunt sensor module 120 has advantages and disadvantages based on a measured item. The Hall sensor module 110 has a faster response time to a change in a current. The shunt sensor module 120 has a less zero offset current and a higher accuracy. The hybrid current sensor assembly 1 is a combination of the Hall sensor module 110 and the shunt sensor module 120 and thus, has a complementary advantage and disadvantage of the two sensors. For example, the hybrid current sensor assembly 1 may use a value measured by at least one of the Hall sensor module 110 and the shunt sensor module 120 depending on a situation, using the microprocessor 123. The Hall sensor module 110 and the shunt sensor module 120 independently measure the current. Thus, when one of the two sensors is broken, the hybrid current sensor assembly 1 may measure the current using another sensor.

Hereinafter, components performing identical functions to the components described in the foregoing will be referred to using the same names of the components described in the foregoing. Unless otherwise specified, the descriptions provided in the foregoing may be applicable to an example embodiment to be described hereinafter, and a repeated description will be omitted.

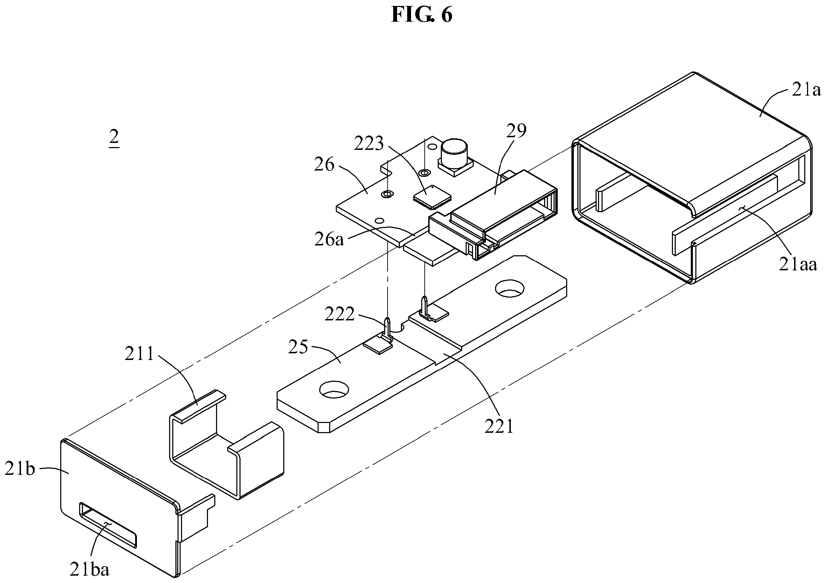

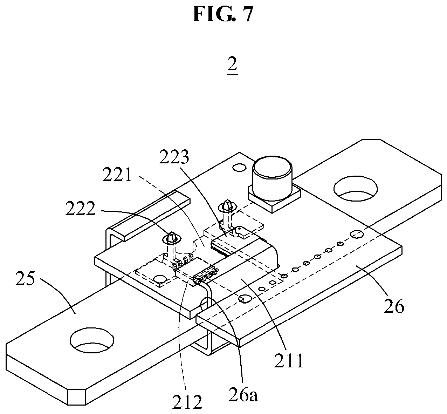

FIG. 6 is an exploded perspective view of a hybrid current sensor assembly 2 according to another embodiment of the present invention, and FIG. 7 is a perspective view of an internal structure of the hybrid current sensor assembly 2.

Referring to FIGS. 6 and 7, the hybrid current sensor assembly 2 includes a housing, a conductor 25, a circuit board 26, a connector 29, a Hall core 211, a Hall sensor 212, a shunt resistance 221, a shunt terminal 222, and a microprocessor 223.

The housing includes a housing body 21a and a housing cover 21b. The housing body 21a includes a first conductor insertion portion (not shown) into which the conductor 25 is inserted. For example, the first conductor insertion portion is a slot formed in the housing body 21a. In FIG. 6, the first conductor insertion portion is formed on a back face of the housing body 21a. The housing body 21a also includes a connector insertion portion 21aa into which the connector 29 is inserted. For example, the connector insertion portion 21aa is a groove formed by being recessed on one side of the housing body 21a.

The housing cover 21b includes a second conductor insertion portion 21ba into which the conductor 25 is inserted. For example, the second conductor insertion portion 21ba is a slot formed in the housing cover 21b. The second conductor insertion portion 21ba is formed on a face corresponding to the first conductor insertion portion.

The conductor 25 is disposed to penetrate the housing. One end portion of the conductor 25 is disposed to penetrate one face of the housing body 21a, and another end portion of the conductor 25 is disposed to penetrate the housing cover 21b.

The circuit board 26 includes a core insertion portion 26a into which the Hall core 211 is inserted. For example, the core insertion portion 26a is a groove linearly recessed in an inward direction from one edge of the circuit board 26.

The Hall core 211 is provided in a form to cover the conductor 25. The Hall core 211 includes a first face covering a bottom side of the conductor 25, a second face and a third face bent from both edges of the first face and covering both sides of the conductor 25, and a first end portion and a second end portion bent correspondingly from the second face and the third face in a direction in which the first end portion and the second end portion face each other. Based on such a form, a magnetic field to be applied to the Hall core 211 may increase. The Hall core 211 is slidingly connected along the core insertion portion 26a. In detail, at least one of the second face and the third face of the Hall core 211 is slidingly connected to the circuit board 26 through the core insertion portion 26a.

The Hall core 211 and the Hall sensor 212 are collectively referred to as a Hall sensor module.

The shunt resistance 221, the shunt terminal 222, and the microprocessor 223 are collectively referred to as a shunt sensor module.

According to example embodiments of the present invention, respective advantages and disadvantages of two types of sensors may be complemented by integrating both types into a single sensor housing. Thus, a faster response speed to a change in a current and a higher accuracy in designing may be achieved. In addition, a production cost and a size of a product may be reduced.

## Claims

1. A hybrid current sensor assembly (1), comprising:
a conductor (15) configured to be connected to both terminals of an external electronic device;
a Hall sensor (112) in which a potential difference occurs at both ends thereof due to a magnetic field applied to a Hall core (111);
a shunt terminal (122);
a shunt resistance (121) configured to shunt the current flowing in the conductor (15);
a microprocessor (123) electrically connected to the shunt terminal (122) and configured to measure the current flowing in the conductor (15); and
a circuit board (16) to which the Hall sensor (112) and the shunt terminal (122) are connected, wherein
the hybrid current sensor assembly (1) comprises the Hall core (111) to which the magnetic field generated by a current flowing in the conductor (15) is applied, wherein the Hall core (111) is configured such that the magnetic field is concentrated on the Hall sensor (112), and comprises a first face to cover a bottom side of the conductor (15), and a second face and a third face bent correspondingly from both edges of the first face and covering both edges of the conductor (15); **characterized in that**
the circuit board (16) has the microprocessor (123) mounted thereto and comprises a core insertion portion (16a) into which the Hall core (111) is inserted.

2. The hybrid current sensor assembly (1) of claim 1, further comprising:
a housing (11) accommodating the Hall core (111), the Hall sensor (112), the shunt terminal (122), and the microprocessor (123), and
wherein at least a portion of the conductor (15) is accommodated in the housing (11), and both end portions of the conductor (15) are externally exposed from the housing (11).

3. The hybrid current sensor assembly (1) of claim 1, wherein the core insertion portion (16a) is a slot formed in the circuit board (16), and at least one of the second face and the third face passes the circuit board (16) through the core insertion portion (16a).

4. The hybrid current sensor assembly (1) of claim 1, wherein the Hall core (111) comprises a first end portion and a second end portion bent correspondingly from the second face and the third face towards a direction in which the first end portion and the second end portion face each other.

5. The hybrid current sensor assembly (1) of claim 4, wherein the core insertion portion (26a) is a groove linearly recessed in an inward direction from an edge of the circuit board (26), and at least one of the second face and the third face is slidingly connected to the circuit board (26) through the core insertion portion (26a).

6. The hybrid current sensor assembly (1) of claim 4, wherein the Hall core (111) is provided in a form so as to cover the conductor (15) and the circuit board (16).

7. The hybrid current sensor assembly (1) of claim 4, wherein the Hall sensor (112) is disposed in a gap formed between the first end portion and the second end portion of the Hall core (111).

8. The hybrid current sensor assembly (1) of claim 1, wherein each connection portion (15a) is a hole formed in the conductor (15).

## Patentansprüche

1. Hybridstromsensoranordnung (1), die Folgendes umfasst:
einen Leiter (15), der zum Verbinden mit beiden Anschlüssen eines externen elektronischen Geräts konfiguriert ist;
einen Hall-Sensor (112), an dessen beiden Enden aufgrund eines an den Hall-Kern (111) angelegten Magnetfeldes eine Potentialdifferenz auftritt;
einen Shunt-Anschluss (122);
einen Shunt-Widerstand (121), der zum Nebenschließen (15) des im Leiter (15) fließenden Stroms konfiguriert ist;
einen Mikroprozessor (123), der elektrisch mit dem Shunt-Anschluss (122) verbunden und zum Messen des im Leiter (15) fließenden Stroms konfiguriert ist; und
eine Leiterplatte (16), mit der der Hall-Sensor (112) und der Shunt-Anschluss (122) verbunden sind, wobei
die Hybridstromsensoranordnung (1) den Hall-Kern (111) umfasst, an den das durch einen im Leiter (15) fließenden Strom erzeugte Magnetfeld angelegt wird, wobei der Hall-Kern (111) so konfiguriert ist, dass das Magnetfeld auf den Hall-Sensor (112) konzentriert wird, und eine erste Fläche zum Abdecken einer Unterseite des Leiters (15) und eine zweite Fläche und eine dritte Fläche umfasst, die entsprechend von beiden Kanten der ersten Fläche gebogen sind und beide Kanten des Leiters (15) abdecken;
**dadurch gekennzeichnet, dass** auf der Leiterplatte (16) der Mikroprozessor (123) montiert ist und sie einen Kerneinführungsabschnitt (16a) umfasst, in den der Hall-Kern (111) eingeführt wird.

2. Hybridstromsensoranordnung (1) nach Anspruch 1, die ferner Folgendes umfasst:
ein Gehäuse (11), das den Hall-Kern (111), den Hall-Sensor (112), den Shunt-Anschluss (122) und den Mikroprozessor (123) aufnimmt, und
wobei mindestens ein Abschnitt des Leiters (15) in dem Gehäuse (11) untergebracht ist und beide Endabschnitte des Leiters (15) von dem Gehäuse (11) extern exponiert sind.

3. Hybridstromsensoranordnung (1) nach Anspruch 1, wobei der Kerneinführungsabschnitt (16a) ein in der Leiterplatte (16) ausgebildeter Schlitz ist und die zweite Fläche und/oder die dritte Fläche die Leiterplatte (16) durch den Kerneinführungsabschnitt (16a) hindurchführt.

4. Hybridstromsensoranordnung (1) nach Anspruch 1, wobei der Hall-Kern (111) einen ersten Endabschnitt und einen zweiten Endabschnitt aufweist, die entsprechend von der zweiten Fläche und der dritten Fläche in eine Richtung gebogen sind, in der der erste Endabschnitt und der zweite Endabschnitt einander gegenüberliegen.

5. Hybridstromsensoranordnung (1) nach Anspruch 4, wobei der Kerneinführungsabschnitt (26a) eine Nut ist, die linear in einer einwärtigen Richtung von einer Kante der Leiterplatte (26) aus vertieft ist, und die zweite Fläche und/oder die dritte Fläche gleitend mit der Leiterplatte (26) durch den Kerneinführungsabschnitt (26a) verbunden ist.

6. Hybridstromsensoranordnung (1) nach Anspruch 4, wobei der Hall-Kern (111) in einer Form vorgesehen ist, um den Leiter (15) und die Leiterplatte (16) zu bedecken.

7. Hybridstromsensoranordnung (1) nach Anspruch 4, wobei der Hallsensor (112) in einem Spalt angeordnet ist, der zwischen dem ersten Endabschnitt und dem zweiten Endabschnitt des Hall-Kerns (111) gebildet ist.

8. Hybridstromsensoranordnung (1) nach Anspruch 1, wobei jeder Verbindungsabschnitt (15a) ein in dem Leiter (15) ausgebildetes Loch ist.

## Revendications

1. Ensemble capteur de courant hybride (1), comprenant :
un conducteur (15) configuré pour être connecté aux deux bornes d'un dispositif électronique externe ;
un capteur à effet Hall (112) dans lequel une différence de potentiel survient au niveau de ses deux extrémités en raison d'un champ magnétique appliqué à un noyau Hall (111) ;
une borne de dérivation (122) ;
une résistance de dérivation (121) configurée pour dériver le courant s'écoulant dans le conducteur (15) ;
un microprocesseur (123) connecté électriquement à la borne de dérivation (122) et configuré pour mesurer le courant s'écoulant dans le conducteur (15) ; et
une carte de circuits (16) à laquelle le capteur à effet Hall (112) et la borne de dérivation (122) sont connectés, où l'ensemble capteur de courant hybride (1) comprend le noyau Hall (111) auquel est appliqué le champ magnétique généré par un courant s'écoulant dans le conducteur (15), où le noyau Hall (111) est configuré de telle sorte que le champ magnétique soit concentré sur le capteur à effet Hall (112), et comprend une première face pour couvrir un côté inférieur du conducteur (15), et une deuxième face et une troisième face fléchies de manière correspondante à partir des deux bords de la première face et couvrant les deux bords du conducteur (15) ;
**caractérisé en ce que** la carte de circuits (16) comporte le microprocesseur (123) lequel est monté sur celle-ci et comprend une portion d'insertion de noyau (16a) dans laquelle le noyau Hall (111) est inséré.

2. Ensemble capteur de courant hybride (1) de la revendication 1, comprenant en outre :
un logement (11) abritant le noyau Hall (111), le capteur à effet Hall (112), la borne de dérivation (122), et le microprocesseur (123), et
où au moins une portion du conducteur (15) est abritée dans le logement (11), et les deux portions d'extrémité du conducteur (15) sont exposées à l'extérieur à partir du logement (11).

3. Ensemble capteur de courant hybride (1) de la revendication 1, où la portion d'insertion de noyau (16a) est une fente formée dans la carte de circuits (16), et au moins une face parmi la deuxième face et la troisième face passe par la carte de circuits (16) à travers la portion d'insertion de noyau (16a).

4. Ensemble capteur de courant hybride (1) de la revendication 1, où le noyau Hall (111) comprend une première portion d'extrémité et une deuxième portion d'extrémité fléchies de manière correspondante à partir de la deuxième face et de la troisième face vers une direction dans laquelle la première portion d'extrémité et la deuxième portion d'extrémité se font face l'une l'autre.

5. Ensemble capteur de courant hybride (1) de la revendication 4, où la portion d'insertion de noyau (26a) est une rainure linéairement en retrait suivant une direction intérieure à partir d'un bord de la carte de circuits (26), et au moins une face parmi la deuxième face et la troisième face est connectée de manière coulissante à la carte de circuits (26) par l'intermédiaire de la portion d'insertion de noyau (26a).

6. Ensemble capteur de courant hybride (1) de la revendication 4, où le noyau Hall (111) est prévu sous une forme de sorte à couvrir le conducteur (15) et la carte de circuits (16).

7. Ensemble capteur de courant hybride (1) de la revendication 4, où le capteur à effet Hall (112) est disposé dans un intervalle formé entre la première portion d'extrémité et la deuxième portion d'extrémité du noyau Hall (111).

8. Ensemble capteur de courant hybride (1) de la revendication 1, où chaque portion de connexion (15a) est un trou formé dans le conducteur (15).
